# FASCICULE DE BREVET EUROPEEN

(11) **EP 2 526 385 B1**
(45) Date de publication et mention de la délivrance du brevet: **01.04.2015**
(21) Numéro de dépôt: 11700423.4
(22) Date de dépôt: 17.01.2011
(51) Int. Cl.: G01D 11/24, G08G 1/02, H05K 5/00, G08C 17/04

(54) **BOÎTIER ÉLECTRONIQUE DESTINÉ À ÊTRE FIXÉ SOUS UN COUVERCLE D'UN REGARD**
ELEKTRONISCHES GEHÄUSE ZUR BEFESTIGUNG AN EINER SCHACHTABDECKUNG
ELECTRONIC HOUSING INTENDED TO BE ATTACHED TO A MANHOLE COVER

(30) Priorité: 21.01.2010 FR 1050401
(43) Date de publication de la demande: 28.11.2012
(73) Titulaire: Eco Compteur, 22300 Lannion (FR)
(72) Inventeur: MILON, Christophe, F-22300 Lannion (FR); ROUGEOLLE, Mathieu, F-22300 Lannion (FR); DUBOIS, Jean-Claude, F-22300 Lannion (FR); GUILLEMETTE, Philippe, F-22300 Lannion (FR)
(74) Mandataire: Maillet, Alain
(86) Numéro de dépôt international: PCT/EP2011/050511
(87) Numéro de publication internationale: WO 2011/089086

(56) Documents cités:
- WO-A1-2006/005208
- US-A- 6 111 519
- US-A1- 2007 018 849
- US-A1- 2009 196 206
- US-B1- 6 246 677

## Description

La présente invention concerne un boîtier électronique disposé sous un couvercle d'un regard de visite, ainsi qu'un ensemble électronique modulaire comportant un tel boîtier électronique.

Il existe des boîtiers électroniques, comme par exemple des boîtiers de comptage pour véhicules ou pour piétons qui sont disposés à l'intérieur du regard de visite, pour éviter les agressions extérieures.

Pour relever les données qui sont mémorisées dans ces boîtiers électroniques, un technicien doit venir régulièrement soulever le couvercle du regard et télécharger lesdites données de la mémoire du boîtier électronique considéré vers une unité de téléchargement, comme par exemple un ordinateur portable.

Le téléchargement s'effectue, par exemple, par l'intermédiaire d'une communication sans fil, par exemple du type liaison Bluetooth.

Le téléchargement des données nécessite donc le soulèvement du couvercle et sa remise en place ce qui constitue un travail long et pénible.

Les documents US-A-2007/0018849, US-B-6,246,677 et US-A-2009/0196206 présentent des boîtiers électroniques.

Un objet de la présente invention est de proposer un boîtier électronique qui ne présente pas les inconvénients de l'art antérieur et qui en particulier permet un téléchargement des données qu'il contient sans avoir à intervenir sur le couvercle qui le protège.

A cet effet, est proposé un boîtier électronique de comptage destiné à être fixé sous un couvercle d'un regard, le couvercle comportant au moins un premier moyen de fixation et un logement traversant, le boîtier électronique comportant :
- une coque présentant une face supérieure,
- pour le ou chaque premier moyen de fixation, un deuxième moyen de fixation destiné à coopérer avec ledit premier moyen de fixation pour fixer ladite coque sous le couvercle,
- des composants électroniques comprenant une mémoire contenant les données de comptage, un module de communication sans fil destiné à transmettre les données mémorisées, et
- un module de commande destiné à faire passer ledit module de communication sans fil d'un mode inactif à un mode actif,
ledit module de commande comprenant un capteur propre à réagir en présence d'un dispositif de réveil extérieur et à entraîner le passage du module de communication sans fil du mode inactif au mode actif, ledit capteur faisant saillie par rapport à ladite face supérieure et destiné à être logé dans ledit logement.

Avantageusement, le module de communication sans fil passe du mode actif au mode inactif, un certain temps après le transfert des données.

Selon un mode de réalisation particulier, chaque premier moyen de fixation est un trou traversant avec un lamage, et en ce que chaque deuxième moyen de fixation est une vis dont la tête vient en appui sur le lamage et dont la tige filetée traverse ledit trou traversant pour se visser dans la coque dans un trou prévu à cet effet.

Selon un mode de réalisation particulier, chaque premier moyen de fixation et chaque deuxième moyen de fixation associés forment ensemble une liaison élastique.

Avantageusement, chaque premier moyen de fixation est un trou traversant avec un lamage, et en ce que chaque deuxième moyen de fixation comporte, d'une part, une vis dont la tête vient en regard dudit lamage et dont la tige filetée traverse ledit trou traversant pour se visser dans la coque dans un trou prévu à cet effet, et, d'autre part, un ressort disposé entre ladite tête et ledit lamage.

Avantageusement, le boîtier électronique comporte une protubérance dans laquelle le capteur est noyé.

Avantageusement, la forme de la protubérance épouse la forme du logement.

Avantageusement, la protubérance est réalisée dans un matériau souple.

Avantageusement, la protubérance est transparente dans le domaine de longueurs d'onde utilisées.

Avantageusement, l'intérieur de la coque est divisé en un compartiment central destiné à recevoir les composants électroniques et au moins un compartiment latéral destiné à recevoir une source d'énergie électrique.

Avantageusement, les composants électroniques sont noyés dans une résine remplissant ledit compartiment central.

L'invention propose également un ensemble électronique modulaire comprenant un boîtier électronique selon l'une des variantes précédentes, et un boîtier électronique complémentaire fixé de manière amovible sous ledit boîtier électronique.

Avantageusement, la fixation s'effectue grâce à un système de fixation à baïonnettes.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente un boîtier électronique selon l'invention,
la Fig. 2 est une vue en coupe d'un exemple d'implantation du boîtier électronique de la Fig. 1,
la Fig. 3 représente un boîtier électronique complémentaire pour un ensemble électronique modulaire selon l'invention,
la Fig. 4 est une vue de dessous du boîtier électronique de la Fig. 1, et
la Fig. 5 montre une variante d'implantation du boîtier électronique selon l'invention.

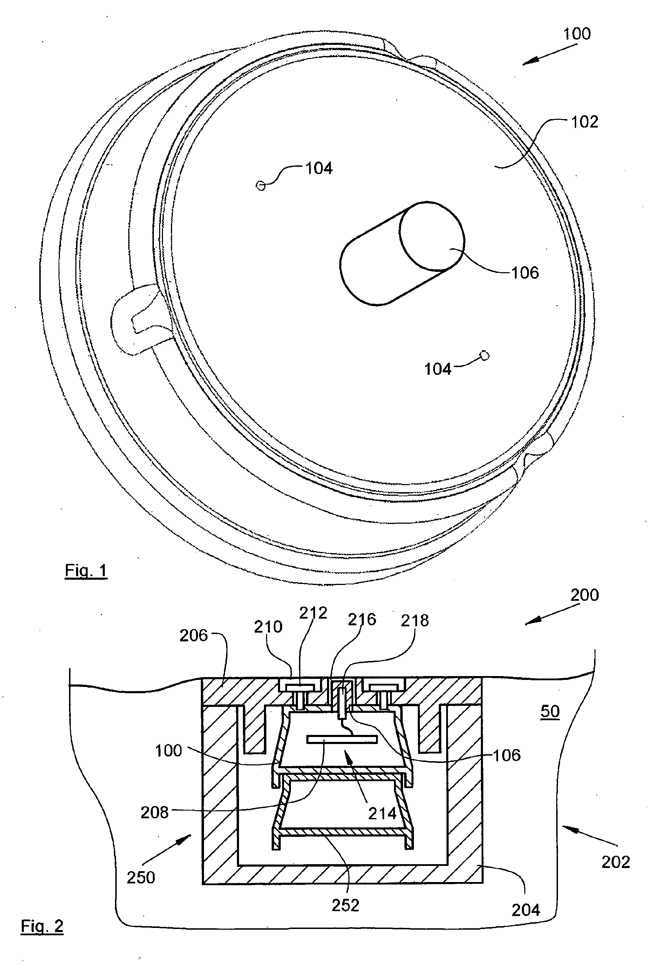

Dans la description qui suit, les termes relatifs à une position sont pris en référence à un boîtier électronique disposé verticalement, c'est-à-dire comme il est représenté sur la Fig. 2.

La Fig. 1 montre un boîtier électronique 100 selon l'invention,

La Fig. 2 montre un exemple d'implantation 200 du boîtier électronique 100 dans un regard 202 placé dans le sol 50.

Le regard 202 prend ici la forme d'un cylindre 204 et d'un couvercle 206.

Le boîtier électronique 100 peut être tout dispositif auquel un technicien doit avoir accès afin de le vérifier ou avec lequel il doit entrer en communication afin de récupérer des données que sa mémoire contient.

Le boîtier électronique 100 peut être un boîtier de comptage de véhicules ou de piétons, un compteur électrique, un compteur de gaz, un compteur d'eau, etc.

A l'intérieur du boîtier électronique 100 sont disposés les composants électroniques 208 nécessaires à son fonctionnement.

Le boîtier électronique 100 comprend une coque 102 qui se présente sous la forme de cuvette renversée, c'est-à-dire que le fond de la cuvette se retrouve en haut et constitue la face supérieure de la coque 102 et l'ouverture de la cuvette se retrouve en bas, ce qui permet d'éviter les infiltrations d'eau par ruissellement.

Pour fermer l'ouverture de la coque 102, le boîtier électronique 100 comprend une paroi montée de manière amovible sous la coque 102. Pour assurer l'étanchéité du boîtier électronique 100, un joint en silicone est disposé autour de la paroi ainsi montée.

Pour éviter que le boîtier électronique 100 soit au fond du regard 202 qui peut être inondé, le boîtier électronique 100 est fixé sous le couvercle 206.

A cette fin, le couvercle 206 comporte au moins un premier moyen de fixation 210, et le boîtier électronique 100 comprend, pour chaque premier moyen de fixation 210, un deuxième moyen de fixation 212, destiné à coopérer avec ledit premier moyen de fixation 210 afin de fixer le boîtier électronique 100 sous le couvercle 206.

Dans le mode de réalisation de l'invention présenté sur les Figs. 1 et 2, les premiers moyens de fixation 210 sont au nombre de deux et prennent chacun la forme d'un trou traversant 210 avec un lamage, chaque deuxième moyen de fixation 212 prend la forme d'une vis dont la tête vient en appui sur le lamage et dont la tige filetée traverse ledit trou traversant pour se visser dans la coque 102 dans un trou 104 prévu à cet effet.

Dans le cas d'un boîtier électrique 100 dont les données doivent être relevées à travers une communication sans fil, les composants électroniques 208 comprennent un module de communication sans fil, par exemple du type module de communication radio (Bluetooth), ou lumineux (infrarouge), etc.

Dans le cas d'un boîtier électronique 100 auto alimenté, c'est-à-dire incluant sa propre source d'énergie, la consommation électrique doit être limitée pour garantir une plus grande longévité de la source d'énergie.

Or un module de communication sans fil est fortement consommateur et pour limiter sa consommation, le boîtier électronique 100 comporte également un module de commande 214 destiné à faire passer le module de communication sans fil d'un mode inactif à un mode actif.

Dans le mode actif, le module de communication sans fil est opérationnel et apte à transmettre des données et recevoir des instructions.

Dans le mode inactif, le module de communication sans fil n'est pas opérationnel.

Pour relever les données de comptage stockées dans la mémoire du boîtier électronique 100, le technicien doit agir sur le module de commande 214 qui commande le passage du module de communication sans fil, du mode inactif au mode actif.

Lorsque le module de communication sans fil est actif, le technicien relève les données en utilisant par exemple un ordinateur ou autre connecté audit module de communication sans fil à travers une liaison sans fil. Le module de communication sans fil transmet ainsi les données mémorisées.

Pour pouvoir agir sur le module de commande 214, celui-ci doit se trouver au moins en partie, accessible depuis l'extérieur du regard 202.

A cette fin, le regard 202, et plus particulièrement le couvercle 206 comporte un logement 216 qui prend la forme d'un trou traversant le couvercle 206, et le module de commande 214 comporte un capteur 218 du type capteur sans contact, comme par exemple un capteur magnétique, qui fait saillie par rapport à la face supérieure de la coque 102 et se loge dans le logement 216.

Le capteur 218 peut être par exemple un interrupteur à lame souple, également appelé 'ILS' ou 'interrupteur reed'.

Le capteur 218 est prévu pour réagir en présence d'un dispositif de réveil extérieur sans contact, comme par exemple une clé magnétique.

Pour des raisons de protections mécaniques, le capteur 218 doit rester à l'intérieur du logement 216 et ne pas sortir hors du regard 202. Les premiers moyens de fixation 210 et les deuxièmes moyens de fixation 212 sont prévus pour autoriser le réglage de la position du boîtier électronique 100 sous le couvercle 206 afin que le capteur 218 ne sorte pas hors du regard 202.

Ainsi, lorsqu'un technicien souhaite relever les données stockées dans le boîtier électronique 100, il approche le dispositif de réveil du capteur 218, ce qui actionne le capteur 218 et déclenche chez le module de commande 214, la commande entraînant le passage du module de communication sans fil, du mode inactif au mode actif.

Après le transfert des données et après un certain temps, le module de communication sans fil passe du mode actif au mode inactif.

La mise en place du capteur 218 dans le logement 216 du couvercle 206 permet donc de faire basculer le module de communication sans fil du mode inactif au mode actif, et de télécharger les données contenues dans le boîtier électronique 100 sans avoir à manipuler le couvercle 206.

Pour protéger le capteur 218, celui-ci est noyé dans une protubérance 106.

Pour éviter que des corps étrangers s'insèrent entre la protubérance 106 et la paroi du logement 216, la forme de la protubérance 106 épouse la forme du logement 216.

Dans le mode de réalisation de l'invention présenté sur les Figs. 1 et 2, la protubérance 106 prend la forme d'un cylindre.

Il est possible qu'un corps étranger, comme un caillou, vienne se loger au sommet de la protubérance, et qu'un véhicule ou un piéton écrase le caillou sur la protubérance 216. Pour éviter que la protubérance 216 se brise sous l'action du caillou, elle est réalisée dans un matériau souple comme par exemple un élastomère thermoplastique de type SEBS avec une dureté de l'ordre de 60 shores.

Il est également possible de prévoir que les composants électroniques 208 incluent des diodes, que ce soit des diodes électroluminescentes qui s'allument pour informer le technicien sur l'état du module de commande 214 et/ou du module de communication sans fil, ou que ce soit des diodes infrarouges de communication. A cette fin, la protubérance 216 est transparente dans le domaine de longueurs d'onde utilisées et sert à guider les ondes des diodes vers l'extérieur et inversement.

Le boîtier électronique 100 peut être associé à au moins un boîtier électronique complémentaire 252 pour constituer un ensemble électronique modulaire 250.

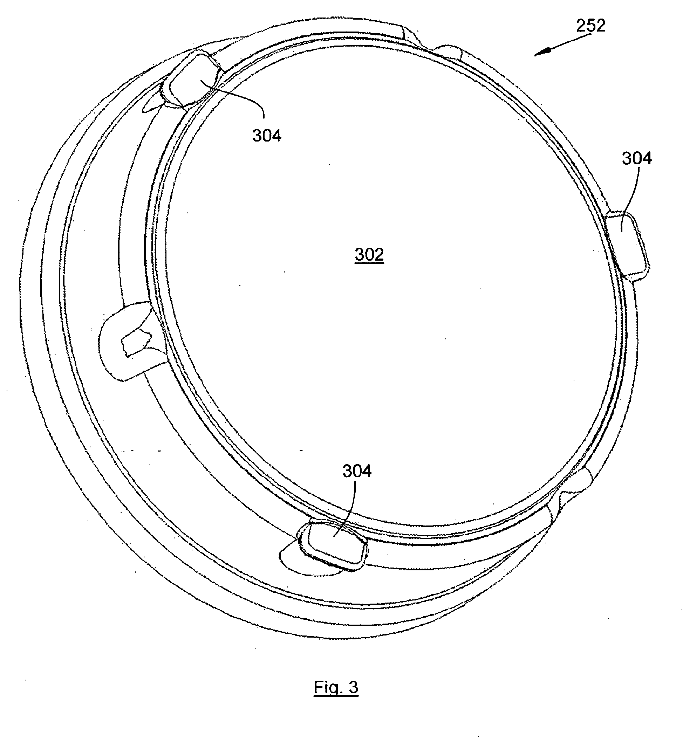

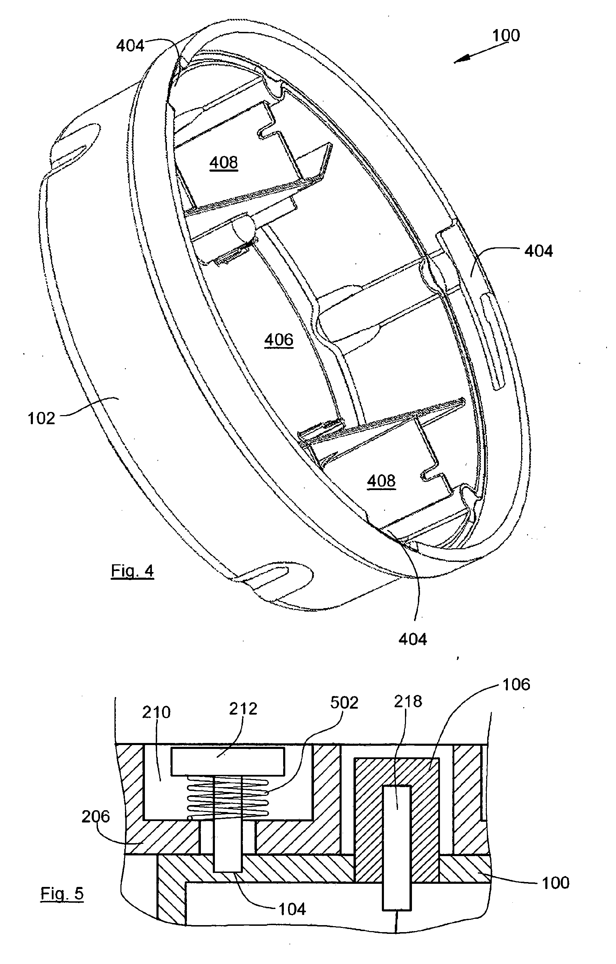

La Fig. 3 montre la coque 302 du boîtier électronique complémentaire 252 et la Fig. 4 montre l'ouverture de la coque 102 du boîtier électronique 100.

Le boîtier électronique complémentaire 252 peut être du même type que le boîtier électronique 100 et il est de préférence relié électroniquement à ce dernier par un câble de connexion afin de pouvoir communiquer avec lui ou avec l'ordinateur du technicien.

L'ensemble électronique modulaire 250 prend la forme d'une colonne qui est ici constituée du boîtier électronique 100 et du boîtier électronique complémentaire 252 qui sont fixés de manière amovible l'un au-dessus de l'autre.

La coque 302 du boîtier électronique complémentaire 252 a la même forme que la coque 102 du boîtier électronique 100. Les coques 102 et 302 présentent un profil qui s'évase en progressant vers leur ouverture respective, ainsi l'emboîtement du boîtier électronique 100 sur le boîtier électronique complémentaire 252 est facilité.

La fixation du boîtier électronique complémentaire 252 sous le boîtier électronique 100 s'effectue grâce à un système de fixation à baïonnettes.

La coque 302 présente au moins deux baïonnettes 304 qui font saillie vers l'extérieur de la coque 302 au sommet de celle-ci.

Pour chaque baïonnette 304, le boîtier électronique 100 comporte au niveau de son ouverture, une fente 404 destinée à recevoir ladite baïonnette 304 et à la maintenir après une rotation du boîtier électronique complémentaire 252. Pour réaliser un verrouillage auto-serrant, les largeurs des fentes 404 se rétrécissent afin d'enserrer les baïonnettes 304.

Bien sûr, le boîtier électronique complémentaire 252 comporte également les mêmes fentes 404 pour permettre la fixation d'un éventuel autre boîtier électronique complémentaire.

L'intérieur de la coque 102, 302 est divisé en une pluralité de compartiments. En particulier, la pluralité comprend un compartiment central 406 et deux compartiments latéraux 408 disposés de part et d'autre du compartiment central 406.

Le compartiment central 406 est destiné à recevoir les composants électroniques 208 qui sont noyés dans une résine remplissant ledit compartiment pour assurer une bonne étanchéité à l'eau.

Chaque compartiment latéral 408 est destiné à recevoir une source d'énergie électrique, telle qu'une batterie.

La Fig. 5 montre un boîtier électronique 100 qui est implanté de manière à être fixé de manière élastique sous le couvercle 206. La mise en place d'une liaison élastique permet de faciliter l'enfoncement du boîtier électronique 100 lorsqu'un élément extérieur appuie dessus, par exemple sur la protubérance 106 que celle-ci soit réalisée dans un matériau souple ou non.

A cette fin, chaque premier moyen de fixation 210 et chaque deuxième moyen de fixation 212, 502 associés forment ensemble ladite liaison élastique.

Dans le mode de réalisation de l'invention présenté sur la Fig. 5, chaque premier moyen de fixation 210 est un trou traversant avec un lamage, et chaque deuxième moyen de fixation 212, 502 comporte, d'une part, une vis 212 dont la tête vient en regard dudit lamage et dont la tige filetée traverse ledit trou traversant pour se visser dans la coque 102 dans le trou 104 prévu à cet effet, et, d'autre part, un ressort 502 disposé entre la tête de vis et le lamage.

Le ressort 502 est ici un ressort hélicoïdal de compression, mais il peut prendre una autre forme tant que le déplacement vers le bas et le retour en position initiale du boîtier électronique 100 sont assurés.

Bien entendu, la présente invention n'est pas limitée aux exemples et modes de réalisation décrits et représentés, mais elle est susceptible de nombreuses variantes accessibles à l'homme de l'art.

## Revendications

1. Boîtier électronique de comptage (100) destiné à être fixé sous un couvercle (206) d'un regard (202), le couvercle (206) comportant au moins un premier moyen de fixation (210) et un logement traversant (216), le boîtier électronique (100) comportant :
- une coque (102) présentant une face supérieure,
- pour le ou chaque premier moyen de fixation (210), un deuxième moyen de fixation (212, 502) destiné à coopérer avec ledit premier moyen de fixation (210) pour fixer ladite coque (102) sous le couvercle
- des composants électroniques (208) comprenant une mémoire contenant les données de comptage, un module de communication sans fil destiné à transmettre les données mémorisées, et
- un module de commande (214) destiné à faire passer ledit module de communication sans fil d'un mode inactif à un mode actif,
le boîtier électronique de comptage (100) étant **caractérisé en ce que** ledit module de commande (214) comprend un capteur (218) propre à réagir en présence d'un dispositif de réveil extérieur et à entraîner le passage du module de communication sans fil du mode inactif au mode actif, et **en ce que** ledit capteur (218) fait saillie par rapport à ladite face supérieure et destiné à être logé dans ledit logement (216).

2. Boîtier électronique de comptage (100) selon la revendication 1, **caractérisé en ce que** le module de communication sans fil passe du mode actif au mode inactif, un certain temps après le transfert des données.

3. Boîtier électronique (100) selon l'une des revendications 1 ou 2, **caractérisé en ce que** chaque premier moyen de fixation (210) est un trou traversant avec un lamage, et **en ce que** chaque deuxième moyen de fixation (212) est une vis dont la tête vient en appui sur le lamage et dont la tige filetée traverse ledit trou traversant pour se visser dans la coque (102) dans un trou (104) prévu à cet effet.

4. Boîtier électronique (100) selon l'une des revendications 1 ou 2, **caractérisé en ce que** chaque premier moyen de fixation (210) et chaque deuxième moyen de fixation (212, 502) associés forment ensemble une liaison élastique.

5. Boîtier électronique (100) selon la revendication 4, **caractérisé en ce que** chaque premier moyen de fixation (210) est un trou traversant avec un lamage, et **en ce que** chaque deuxième moyen de fixation (212, 502) comporte, d'une part, une vis (212) dont la tête vient en regard dudit lamage et dont la tige filetée traverse ledit trou traversant pour se visser dans la coque (102) dans un trou (104) prévu à cet effet, et, d'autre part, un ressort (502) disposé entre ladite tête et ledit lamage.

6. Boîtier électronique (100) selon l'une des revendications 1 à 5, **caractérisé en ce qu'**il comporte une protubérance (106) dans laquelle le capteur (218) est noyé.

7. Boîtier électronique (100) selon la revendication 6, **caractérisé en ce que** la forme de la protubérance (106) épouse la forme du logement (216).

8. Boîtier électronique (100) selon l'une des revendications 6 ou 7, **caractérisé en ce que** la protubérance (106) est réalisée dans un matériau souple.

9. Boîtier électronique (100) selon l'une des revendications 1 à 8, **caractérisé en ce que** la protubérance (106) est transparente dans le domaine de longueurs d'onde utilisées.

10. Boîtier électronique (100) selon l'une des revendications 1 à 9, **caractérisé en ce que** l'intérieur de la coque (102) est divisé en un compartiment central (406) destiné à recevoir les composants électroniques (208) et au moins un compartiment latéral (408) destiné à recevoir une source d'énergie électrique.

11. Boîtier électronique (100) selon la revendication 10, **caractérisé en ce que** les composants électroniques (208) sont noyés dans une résine remplissant ledit compartiment central (406).

12. Ensemble électronique modulaire (250) comprenant un boîtier électronique (100) selon l'une des revendications 1 à 11, et un boîtier électronique complémentaire (252) fixé de manière amovible sous ledit boîtier électronique (100).

13. Ensemble électronique modulaire (250) selon la revendication 12, **caractérisé en ce que** la fixation s'effectue grâce à un système de fixation à baïonnettes.

## Patentansprüche

1. Zähler-Elektronikgehäuse (100), welches dazu bestimmt ist, unter einem Deckel (206) eines Schaulochs (202) befestigt zu werden, wobei der Deckel (206) mindestens ein erstes Befestigungsmittel (210) und eine durchgehende Aufnahme (216) aufweist, wobei das Elektronikgehäuse (100) folgendes aufweist:
- eine Schale (102), die eine Oberseite aufweist,
- für das oder jedes erste Befestigungsmittel (210) ein zweites Befestigungsmittel (212, 502), das dazu bestimmt ist, mit dem ersten Befestigungsmittel (210) zusammenzuwirken, um die Schale (102) unter dem Deckel (206) zu befestigen,
- elektronische Bauteile (208) mit einem Speicher, der die Zählerdaten enthält, und einem drahtlosen Kommunikationsmodul, das dazu bestimmt ist, die gespeicherten Daten zu übertragen,
- ein Steuermodul (214), das dazu bestimmt ist, zu bewirken, dass das drahtlose Kommunikationsmodul aus einer inaktiven Betriebsart in eine aktive Betriebsart wechselt,
wobei das Zähler-Elektronikgehäuse (100) **dadurch gekennzeichnet** ist, dass das Steuermodul (214) einen Sensor (218) umfasst, der dafür eingerichtet ist, in Gegenwart einer äußeren Weckvorrichtung zu reagieren und den Wechsel des drahtlosen Kommunikationsmoduls aus der inaktiven Betriebsart in die aktive Betriebsart zu bewirken, und dass der Sensor (218) bezüglich der Oberseite vorsteht und dazu bestimmt ist, in der Aufnahme (216) aufgenommen zu werden.

2. Zähler-Elektronikgehäuse (100) nach Anspruch 1, **dadurch gekennzeichnet, dass** das drahtlose Kommunikationsmodul eine gewisse Zeit nach der Übertragung der Daten aus der aktiven Betriebsart in die inaktive Betriebsart wechselt.

3. Elektronikgehäuse (100) nach einem der Ansprüche 1 oder 2, **dadurch gekennzeichnet, dass** jedes erste Befestigungsmittel (210) ein Durchgangsloch mit einer Flachsenkung ist und dass jedes zweite Befestigungsmittel (212) eine Schraube ist, deren Kopf an der Flachsenkung zur Anlage kommt und deren Gewindeschaft durch das Durchgangsloch läuft, um in der Schale (102) in ein zu diesem Zweck vorgesehenes Loch (104) eingeschraubt zu werden.

4. Elektronikgehäuse (100) nach einem der Ansprüche 1 oder 2, **dadurch gekennzeichnet, dass** jedes erste Befestigungsmittel (210) und jedes zugeordnete zweite Befestigungsmittel (212, 502) zusammen eine elastische Verbindung bilden.

5. Elektronikgehäuse (100) nach Anspruch 4, **dadurch gekennzeichnet, dass** jedes erste Befestigungsmittel (210) ein Durchgangsloch mit einer Flachsenkung ist und dass jedes zweite Befestigungsmittel (212, 502) einerseits eine Schraube (212) aufweist, deren Kopf in eine Position gegenüber der Flachsenkung gelangt und deren Gewindeschaft durch das Durchgangsloch läuft, um in der Schale (102) in ein zu diesem Zweck vorgesehenes Loch (104) eingeschraubt zu werden, und andererseits eine Feder (502), die zwischen dem Kopf und der Flachsenkung angeordnet ist.

6. Elektronikgehäuse (100) nach einem der Ansprüche 1 bis 5, **dadurch gekennzeichnet, dass** es einen Vorsprung (106) aufweist, in welchen der Sensor (218) eingebettet ist.

7. Elektronikgehäuse (100) nach Anspruch 6, **dadurch gekennzeichnet, dass** die Form des Vorsprungs (106) an die Form der Aufnahme (216) angepasst ist.

8. Elektronikgehäuse (100) nach einem der Ansprüche 6 oder 7, **dadurch gekennzeichnet, dass** der Vorsprung (106) aus einem nachgiebigen Material hergestellt ist.

9. Elektronikgehäuse (100) nach einem der Ansprüche 1 bis 8, **dadurch gekennzeichnet, dass** der Vorsprung (106) im Bereich der verwendeten Wellenlängen durchlässig ist.

10. Elektronikgehäuse (100) nach einem der Ansprüche 1 bis 9, **dadurch gekennzeichnet, dass** das Innere der Schale (102) in ein mittleres Fach (406), das dazu bestimmt ist, die elektronischen Bauteile (208) aufzunehmen, und mindestens ein seitliches Fach (408), das dazu bestimmt ist, eine elektrische Energiequelle aufzunehmen, aufgeteilt ist.

11. Elektronikgehäuse (100) nach Anspruch 10, **dadurch gekennzeichnet, dass** die elektronischen Bauteile (208) in Harz eingebettet sind, welches das mittlere Fach (406) ausfüllt.

12. Modulare Elektronikanordnung (250), welche ein Elektronikgehäuse (100) nach einem der Ansprüche 1 bis 11 und ein zusätzliches Elektronikgehäuse (252), welches unter dem Elektronikgehäuse (100) befestigt lösbar ist, umfasst.

13. Modulare Elektronikanordnung (250) nach Anspruch 12, **dadurch gekennzeichnet, dass** die Befestigung mithilfe eines Befestigungssystems mit Bajonettverschluss erfolgt.

## Claims

1. Electronic counting housing (100) intended to be attached underneath a cover (206) of a manhole (202), the cover (206) comprising at least one first attachment means (210) and a through-cavity (216), the electronic housing (100) comprising:
- a shell (102) having an upper surface,
- for the or each first attachment means (210), a second attachment means (212, 502) intended to engage with said first attachment means (210) in order to attach said shell (102) underneath the cover (206),
- electronic components (208) comprising a memory containing counting data, a wireless communication module intended to transmit the stored data, and
- a control module (214) intended to shift said wireless communication module from an inactive mode to an active mode,
the electronic counting housing (100) being **characterised in that** said control module (214) comprises a sensor (218) capable of reacting in the presence of an external wake-up device and causing the wireless communication module to shift from inactive mode to active mode, and **in that** said sensor (218) projects from said upper surface and is intended to be housed inside said cavity (216).

2. Electronic counting housing (100) according to claim 1, **characterised in that** the wireless communication module shifts from active mode to inactive mode a certain time after the transfer of data.

3. Electronic housing (100) according to one of claims 1 or 2, **characterised in that** each first attachment means (210) is a through-hole with a countersink, and **in that** each second attachment means (212) is a screw the head of which rests on the countersink and the threaded stem of which passes through said through-hole in order to be screwed into the shell (102) in a hole (104) provided for the purpose.

4. Electronic housing (100) according to one of claims 1 or 2, **characterised in that** each first attachment means (210) and each associated second attachment means (212, 502) together form an elastic connection.

5. Electronic housing (100) according to claim 4, **characterised in that** each first attachment means (210) is a through-hole with a countersink, and **in that** each second attachment means (212, 502) comprises, firstly, a screw (212) the head of which rests on said countersink and the threaded stem of which passes through said through-hole in order to be screwed into the shell (102) in a hole (104) provided for the purpose, and, secondly, a spring (502) positioned between said head and said countersink.

6. Electronic housing (100) according to one of claims 1 to 5, **characterised in that** it comprises a protuberance (106) in which the sensor (218) is embedded.

7. Electronic housing (100) according to claim 6, **characterised in that** the shape of the protuberance (106) matches the shape of the cavity (216).

8. Electronic housing (100) according to one of claims 6 or 7, **characterised in that** the protuberance (106) is made from a flexible material.

9. Electronic housing (100) according to one of claims 1 to 8, **characterised in that** the protuberance (106) is transparent in the range of wavelengths used.

10. Electronic housing (100) according to one of claims 1 to 9, **characterised in that** the interior of the shell (102) is divided into a central compartment (406) intended to accept the electronic components (208) and at least one side compartment (408) intended to accept an electrical energy source.

11. Electronic housing (100) according to claim 10, **characterised in that** the electronic components (208) are embedded in a resin filling said central compartment (406).

12. Modular electronic assembly (250) comprising an electronic housing (100) according to one of claims 1 to 11 and an additional electronic housing (252) attached detachably underneath said electronic housing (100):

13. Modular electronic assembly (250) according to claim 12, **characterised in that** attachment takes place by means of a bayonet attachment system.
